Europäisches Patentamt

European Patent Office

Office européen des brevets

(19)

(11) EP 1 589 540 A1

(12) EUROPEAN PATENT APPLICATION
published in accordance with Art. 158(3) EPC

(43) Date of publication:
26.10.2005 Bulletin 2005/43

(51) Int Cl.$^7$: **H01B 1/20**, H05K 1/11,
H05K 3/40, H05K 1/09

(21) Application number: 04703883.1

(22) Date of filing: 21.01.2004

(86) International application number:
PCT/JP2004/000460

(87) International publication number:
WO 2004/066316 (05.08.2004 Gazette 2004/32)

(84) Designated Contracting States:
AT BE BG CH CY CZ DE DK EE ES FI FR GB GR
HU IE IT LI LU MC NL PT RO SE SI SK TR
Designated Extension States:
AL LT LV MK

(30) Priority: 23.01.2003 JP 2003014553
23.01.2003 JP 2003014554
23.01.2003 JP 2003014555
23.01.2003 JP 2003014556

(71) Applicant: MATSUSHITA ELECTRIC INDUSTRIAL
CO., LTD.
Kadoma-shi, Osaka 571-8501 (JP)

(72) Inventors:
• SUGITA, Yuichiro
- (JP)
• TAKENAKA, Toshiaki
- (JP)

(74) Representative: Grünecker, Kinkeldey,
Stockmair & Schwanhäusser Anwaltssozietät
Maximilianstrasse 58
80538 München (DE)

(54) **CONDUCTIVE PASTE, METHOD FOR PRODUCING SAME, CIRCUIT BOARD USING SUCH CONDUCTIVE PASTE AND METHOD FOR PRODUCING SAME**

(57)    It is intended to reliably form high-quality via-hole conductor with less variation, and to realize a circuit forming board having excellent connection reliability. It provides a conductive paste comprising primary particles and agglomerate of primary particles, conductive particles of 0.5 to 20 μm in average particle diameter and 0.07 to 1.7 m$^2$/g in specific surface area, and a binder based on thermosetting resin, and also provides an inexpensive circuit forming board with high connection reliability by using the paste.

FIG. 1

Agglomeration degree 1.60

**EP 1 589 540 A1**

**Description**

TECHNICAL FIELD

The present invention relates to a conductive paste which can be used for filling via-holes for electrical connection between compositions of conductive paste used for a circuit forming board used in various electronic apparatuses, particularly between layers in a multi-layered board, a method of manufacturing the conductive paste, a circuit forming board using the conductive paste, and its manufacturing method.

BACKGROUND ART

Recently, as electronic apparatuses are rapidly reduced in size and increased in density, double-sided and multi-layered boards are more and more employed in place of conventional single-sided boards as circuit forming boards for mounting electronic components, and developments are now directed toward providing high-density circuit forming boards capable of integrating as many circuits as possible thereon.

In a circuit forming board, instead of layer-to-layer connection by through-hole machining and plating as is conventionally widely employed; proposed is a circuit forming board of inner via-hole structure using conductive paste capable of realizing connection between layers at a predetermined position in higher density.

A circuit forming board of inner via-hole structure is such that releasing film is affixed by lamination to both surfaces of an insulative prepreg sheet, and a through-hole is formed in this sheet by using a laser beam or the like. The through-hole is filled with conductive paste, and after the releasing film is removed, metallic foil is disposed on both surfaces of the prepreg sheet and heated under pressure, thereby realizing electrical connection of both surfaces of an insulating board through via-hole conductor (inner via-hole) disposed in the via-hole. A circuit can be formed into a predetermined pattern by selectively etching the metallic foil.

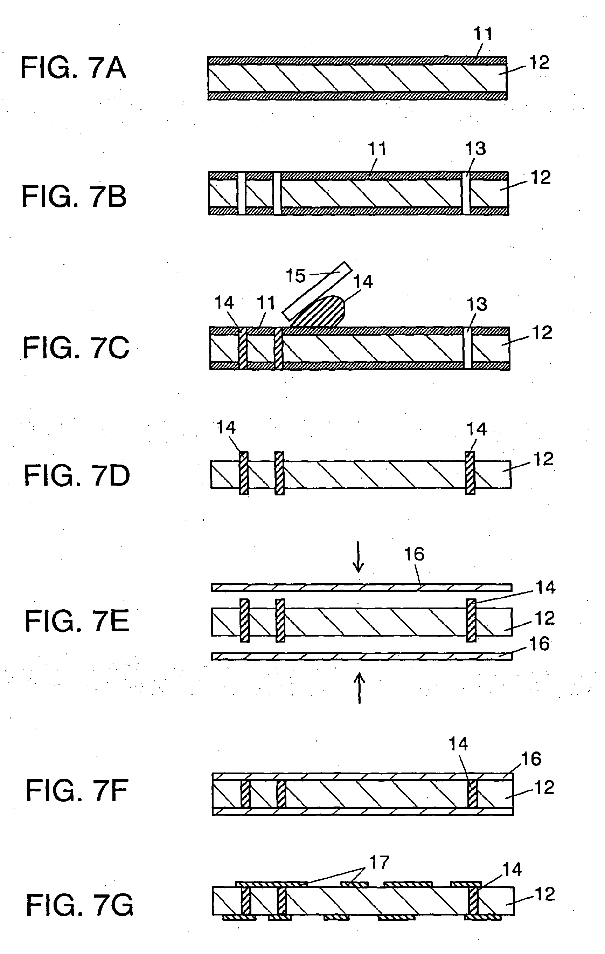

A method of manufacturing a conventional circuit forming board of via-hole structure will be described in the following with reference to the drawings. Fig. 7A to Fig. 7G are sectional views showing the manufacturing process of a conventional circuit forming board.

First, as shown in Fig. 7A, for example, releasing film 11, formed by applying a releasing agent such as silicone type to PET (polyethylene phthalate) film is affixed to both sides of insulating board 12.

As insulating board 12, for example, prepared is woven or non-woven cloth formed of inorganic or organic fiber impregnated with thermosetting resin. Representative one used is a composite material, woven cloth of glass fiber impregnated with epoxy resin, or a composite material, non-woven cloth of aramide fiber impregnated with epoxy resin, of which epoxy resin is half-hardened, that is, a prepreg sheet in a state of B-stage.

Next, as shown in Fig. 7B, through-hole 13 is formed at a predetermined position of insulating board (prepreg sheet) 12 formed of prepreg sheet by means of a laser beam or drill.

Next, as shown in Fig. 7C, conductive paste 14 is filled into through-hole 13 from above releasing film 11. It is preferable to discharge the paste from a nozzle of a dispenser or the like for the filling purpose. Also, the paste can be filled from either side of insulating board (prepreg sheet) 12, but taking into account the productivity and cost, as shown in Fig. 7C, it is practical in many cases to carry out the filling by a printing method using urethane rubber or squeegee 15 on a printing machine table (not shown). In this case, releasing film 11 serves as a printing mask and as a contamination preventing film for insulating board (prepreg sheet) 12.

Next, as shown in Fig. 7D, after releasing film 11 is removed from both surfaces of insulating board (prepreg sheet) 12, insulating board (prepreg sheet) 12 is sandwiched between metallic foils 16 as shown in Fig. 7E. Insulating board (prepreg sheet) 12 and metallic foil 16 are bonded to each other as shown in Fig. 7F when heated and pressurized by using a hot press (not shown). Simultaneously, insulating board (prepreg sheet) 12 and conductive paste 14 filled in through-holes 13 are compressed. Thus, metallic foils 16 on both surfaces are electrically connected to each other by conductive paste 14.

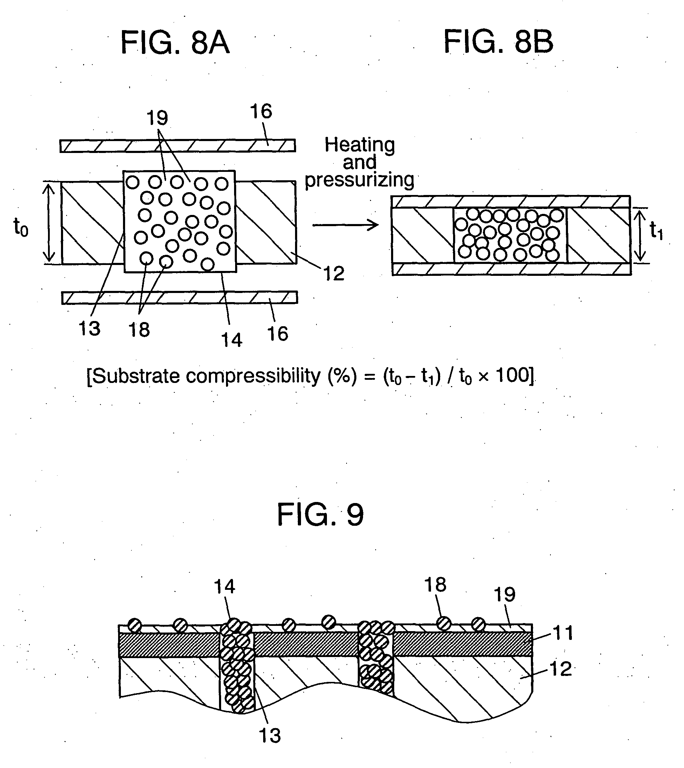

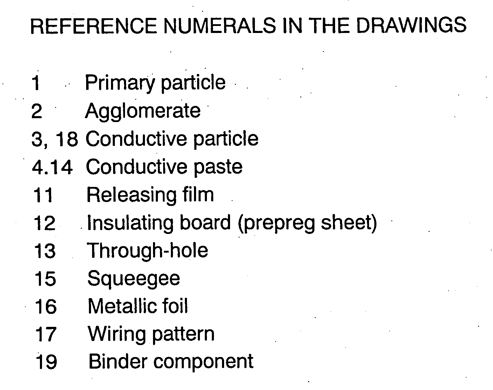

The generating mechanism of this electrical conduction is further described by using Fig. 8A and Fig. 8B.

Fig. 8A and Fig. 8B correspond to Fig. 7E and Fig. 7F respectively. These figures show schematic views of via-hole cross-section, and conductive paste 14 comprises binder component 19 and additives, containing conductive particles 18 and thermosetting resin as main components. When heated and pressurized, insulating board (prepreg sheet) 12 is compressed in thickness from $t_0$ of Fig. 8A to $t_1$ of Fig. 8B, then conduction is obtained as interfacial contact takes place between conductive particles and between conductive particle and metallic foil 16. The compressibility of the substrate can be represented as follows:

$$\text{Substrate compressibility (\%)} = (t_0 - t_1) / t_0 \times 100$$

where $t_0$ and $t_1$ respectively stand for thickness before and after heating under pressure of insulating board (prepreg sheet) 12.

After that, as shown in Fig. 7G, a circuit forming board is obtained by forming wiring pattern 17 by selectively etching metallic foils 16 on both surfaces. The inner via connecting technique using conductive paste 14 is relatively simple in process and excellent in productivity and is able to realize a high-density circuit forming board at a relatively low cost. It is as low as a few mΩ or less in resistance value per via, and displays excellent connection reliability even in load tests by heating, humidifying, and thermal shocks.

As prior art related to the present invention, for example, it is disclosed in Japanese Laid-open Patent H6-268345.

Now, as for applications in high-frequency circuits capable of high-speed transmission as high-density circuit forming boards and in fine wiring patterns such as semiconductor package and in portable electronic equipment required to be reduced in size and weight, it is important to improve the conducting connection reliability, for example, lowering the resistance, enhancing the reliability, and reducing the variation of resistance value with respect to inner via. Also, in the case of electronic equipment such as household portable telephones, there has been a severe request for the manufacturing cost.

As is predictable from Fig. 8A and Fig. 8B already described, for improving the conducting connection reliability of inner via, it is necessary to pay attention to the state of contact between conductive particles. Also, regarding the cost, manufacturing as many circuit forming boards as possible with use of a specific amount of paste is directly related to the cost reduction, and there has been a strong demand for improving the processing number of sheets of via-filled insulating boards (prepreg sheet) 12, that is, cost reduction by improving the productivity.

Fig. 9 is a sectional view schematically showing the section of insulating board (prepreg sheet) 12 after printing and filling conductive paste 14 shown in Fig. 7C into through-hole 13 by using squeegee 15.

Fig. 9 shows a state such that a layer of liquid binder component 19 is formed on the surface of releasing film 11 and there remains a little amount of conductive particles 18.

Thus, in the filling process of conductive paste 14, liquid binder component 19 is filtered off from conductive paste 14 and remains on the surface of releasing film 11.

This process includes continuous printing, repetition of filling the paste into new insulating boards (prepreg sheet) 12 one after another, and the liquid binder is filtered off from the conductive paste one after another, and solid conductive particles slowly become rich, that is, the conductive particles in the conductive paste increase in abundance, causing the viscosity to be increased.

Also, in the conductive paste filling process, it can be predicted that the state of dispersion of conductive particles to the liquid binder is varied and hardening of thermosetting resin is promoted by the share stress of squeezing. The increase of the viscosity extremely worsens the filling into fine through-holes. Accordingly, it can be considered that a composition capable of suppressing such viscosity increase, that is, decreasing the viscosity will lead to improving the processing number of sheets of insulating boards (prepreg sheet) 12.

However, the conductive paste involves the following three problems, and it is difficult to solve these problems and to achieve both purposes of improving the conducting connection reliability and reducing the cost by improving the productivity.

(Problem 1)

It is a fact that conductor resistance can be decreased when conductive particles that make the inner via-hole internally conductive are greater in abundance. Therefore, it is necessary for the conductive paste to contain as many conductive particles as possible. However, in mixing of solid conductive particles and liquid binder, the mixing ratio possible for making a paste is limited, and if the viscosity is too high, it will affect the smoothness of filling into via.

As for the productivity, in the process of filling the conductive paste into via as described earlier, the processing number of sheets of insulating boards (prepreg sheet) 12 is more effective when the conductive paste is lower in viscosity. Accordingly, a conductive paste of low viscosity containing a lot of conductive particles is requested.

(Problem 2)

Since metallic foil 16 and insulating board 12 are heated and pressurized to form inner via-holes, if a lot of volatile component is contained in conductive paste 14, the steam pressure in the inner via-hole will be increased during heating and there is a possibility that defective connection takes place due to swelling. Accordingly, it is necessary for the conductive paste to have low volatility.

That is, the water content is desirable to be lower, and when a solvent is used for adjusting the viscosity as is used for generally well-known thick film circuit forming paste, the amount added is limited, and it is desirable to be as little as possible.

(Problem 3)

A binder based on thermosetting resin is an important factor with respect to the connection reliability of inner via-holes. And taking into account the matching with insulating board (prepreg sheet) 12, the types of resin and hardener selected are determined according to the characteristics required for the circuit forming board and inner via-holes. Accordingly, it is sometimes unable to freely make the selection on the assumption that the resin viscosity is limited, and further, it is sometimes unable to freely blend it with conductive particles with respect to the mixing ratio.

The present invention is intended to solve the above problems. That is, it is able to meet inconsistent requirements for containing as many conductive particles as possible with respect to the conducting connection reliability, and on the other hand, for suppressing the amount of conductive particles in order to improve the productivity as much as possible. Also, it is possible to provide conductive paste suited for via-hole conductor, and the object is to provide a circuit forming board using the paste, and its manufacturing method.

DESCLOSURE OF THE INVENTION

The conductive paste of the present invention comprises conductive particles comprising primary particles and agglomerate of primary particles, which are 0.5 to 20 µm in average particle diameter and 0.07 to 1.7 $m^2$/g in specific surface area, and a binder based on thermosetting resin.

Also, the conductive paste of the present invention is a conductive paste comprising conductive particles of 0.5 to 20 µm in average particle diameter and 0.07 to 1.7 $m^2$/g in specific surface area, having at least two peaks of particle size distribution, and a binder based on thermosetting resin. Or, it comprises conductive particles formed by mixing conductive particles of at least two different particle size distributions and a binder based on thermosetting resin.

Also, the conductive paste of the present invention comprises conductive particles formed by mixing conductive particles of at least two different particle size distributions and a binder based on thermosetting resin.

Because of these, in the present invention, conductive particles in the conductive paste can be dispersed with high dispersibility into the binder based on thermosetting resin. Thus, conductive paste with lowered viscosity can be obtained. Also, it is possible to improve the state of contact between conductive particles in inner via-hole and to avoid variation of the state of contact. As a result, it is possible to provide a circuit board capable of achieving both purposes of improving the connection reliability and reducing the cost by improving the productivity.

Also, the conductive paste manufacturing method of the present invention is a conductive paste manufacturing method comprising the steps of preparing conductive particles, measuring the degree of agglomeration (agglomeration degree = agglomerate particle average diameter/primary particle average diameter) of conductive particles, disaggregating the conductive particles according to the measured result of agglomeration degree, and adding a binder thereto and kneading. Or, a conductive paste manufacturing method comprising the steps of preparing conductive particles having at least two peaks of particle size distribution, and adding a binder thereto and kneading, or a conductive paste manufacturing method comprising the steps of: preparing conductive particles of at least two different particle size distributions, mixing them, and adding a binder thereto and kneading in order to provide a conductive paste and manufacture a circuit forming board by using the paste.

In the above method, conductive particles in the conductive paste are dispersed with high dispersibility into a binder based on thermosetting resin in order to manufacture a conductive paste with lowered viscosity, and it is possible to improve the state of contact between conductive particles in inner via-hole and to avoid variation of the state of contact. In this way, the object is to provide an excellent conductive paste capable of achieving both purposes of improving the connection reliability and reducing the cost by improving the productivity, and to realize a highly reliable circuit forming board using the conductive paste.

Also, the circuit board manufacturing method of the present invention provides a conductive particle measuring method comprising the steps of obtaining the average diameter of primary particles, obtaining the average diameter of agglomerate particles, and calculating by using the following formula for the measurement of conductive particles including primary particles and agglomerate of primary particles, and thereby, conductive particles contained in the conductive paste are numerically measured. And, according to such measuring method, a conductive paste is manufactured and a circuit forming board using the conductive paste is manufactured.

Thus, conductive particles in conductive paste are dispersed with high dispersibility into a binder based on thermosetting resin in order to manufacture conductive paste with lowered viscosity, and it is possible to improve the state of contact between the conductive particles in inner via-hole and to avoid variation of the state of contact. Accordingly, it is possible to provide a conductive paste capable of meeting both purposes of improving the connection reliability and reducing the cost by improving the productivity, and to realize a highly reliable circuit forming board using the conductive paste.

Also, the circuit forming board of the present invention is a circuit forming board comprising an insulating board and a plurality of wiring patterns formed on the insulating board, and via-hole conductor for electrically connecting the wiring patterns, wherein used as via-hole conductor is a conductive paste comprising conductive particles comprising primary particles and agglomerate particles of primary particles of 0.5 to 20 μm in average particle diameter and 0.07 to 1.7 m$^2$/g in specific surface area, and a binder based on thermosetting resin, or a conductive paste comprising conductive particles having at least two peaks of particle size distributions of 0.5 to 20 μm in average particle diameter and 0.07, to 1.7 m$^2$/g in specific surface area, and a binder based on thermosetting resin, or a conductive paste comprising conductive particles formed by mixing conductive particles of at least two different particle size distributions, and a binder based on thermosetting resin.

BRIEF DESCRIPTION OF THE DRAWINGS

Fig. 1 is a schematic diagram showing conductive particles in the preferred embodiment 1 of the present invention. Fig. 2 is a schematic diagram of other conductive particles in the preferred embodiment 1 of the present invention. Fig. 3 is a schematic diagram of conductive particles different in agglomeration from the preferred embodiment 1 of the present invention. Fig. 4A to Fig. 4B are diagrams showing the particle size distribution of conductive particles in the preferred embodiment 3 of the present invention. Fig. 5 is a diagram showing the correlation between agglomeration degree, viscosity and resistance value. Fig. 6A to Fig. 6G are process diagrams showing a circuit forming board manufacturing method of the present invention. Fig. 7A to Fig. 7G are process diagrams showing a conventional circuit forming board manufacturing method. Fig. 8A to Fig. 8B are process diagrams showing a generating mechanism of conduction of the circuit forming board. Fig. 9 is a sectional view showing a state after filling conductive paste into through-holes.

DETAILED DESCRIPTION OF THE PREFERRED EMBODIMENT

(Preferred embodiment 1)

The preferred embodiment 1 will be described with reference to the drawings.

To describe the features of the present invention briefly, it is to accurately control the agglomeration and particle size distribution with respect to metallic powder such as copper, silver or gold, alloy powder or metal powder coated with different kinds of metal as conductive particles of conductive paste. As a measuring instrument for particle size distribution of conductive particles, a laser diffraction scattering system is widely employed in the power industry, and instruments such as Microtrack of Nikkiso Co.,Ltd make as wet type, and HELOS of SYMPATECH make as dry type are well-known.

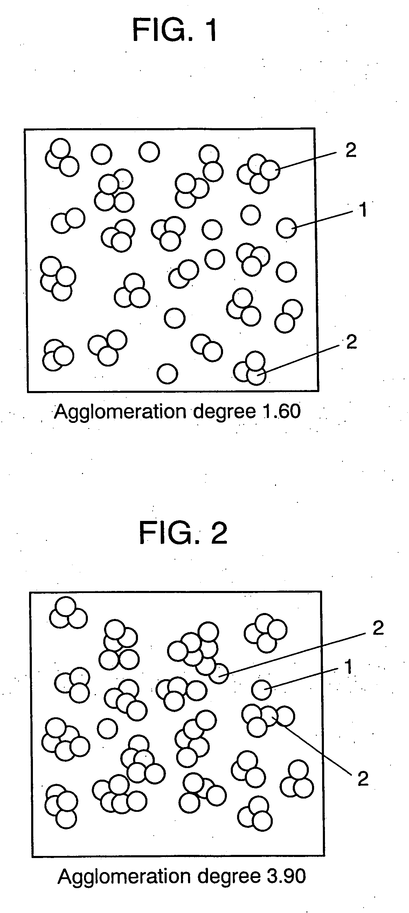

Fig. 1 is a plan view schematically showing a state of agglomeration of copper powder of conductive paste related to the preferred embodiment 1. As shown in Fig. 1, the copper particle as conductive particle related to the preferred embodiment 1 is an aggregate of primary particle 1 being spherical and agglomerate particle 2 of at least two primary particles 1. It is 0.5 to 20 μm in average particle diameter, 0.07 to 1.7 m$^2$/g in specific surface area, and 1.60 in agglomeration degree. Accordingly, it is possible to increase the chance of contacting between conductive particles and to obtain an effect of lowering the via-hole conductor resistance value as a result.

Here, the agglomeration degree is an index showing the degree of agglomeration of agglomerate particles, which can be defined as a value obtained by dividing the average diameter of agglomerate particles by the average diameter of primary particles. That is, it can be represented by (agglomeration degree = agglomerate particle average diameter/primary particle average diameter).

As for the particle size distribution measured by a laser diffraction scattering system mentioned above, when a few particles are agglomerated, there is a possibility that the measurement is made on agglomerate instead of measuring the particle diameter of each particle, that is, primary particle. Accordingly, when aggregate of particles including agglomerate such as conductive particles is measured, the result of particle size distribution obtained is a result of calculating one particle of agglomerate and it will not reflect the particle size distribution of actual particles.

On the other hand, irrespective of whether the particles are agglomerated or not, as a method of measuring the particle size distribution by dividing it into one particle or primary particle, the image of particles observed by using SEM (scanning type electronic microscope) is subjected to image analysis, by which a particle size distribution being approximate to the spherical shape of primary particle can be obtained.

Since any one of the particle size distribution measuring methods is not a measuring method taking agglomeration property into account, the result of particle size distribution obtained is not in a complete correlation with the viscosity of conductive paste, filling into via property, and resistance value of via-hole conductor. And, in the present invention, the agglomeration property of conductive particles is taken into account, paying attention to the agglomeration degree as an index.

As an example of a measuring method for the agglomeration degree of conductive particles related to the present invention, using the average particle diameter, measured by the particle size distribution measuring instrument of laser diffraction scattering system, as agglomerate average diameter, and the average particle diameter, obtained through image analysis of SEM image, as the primary particle average diameter, the agglomeration degree as described above is calculated as follows:

Agglomeration degree = agglomerate average diameter/primary particle

average diameter.

In the preferred embodiment 1, SEM image is used for the calculation of primary particle average diameter, but it is also preferable to use an image taken by a CCD camera or optical microscope. For example, it is preferable to use the data obtained by a particle size distribution measuring instrument which executes image processing of particle information such as FPIA marketed by Sysmex Corporation, and Multi-Image Analyzer of Beckman Coulter Inc.

Thus, according to the present invention, it is possible to give the agglomeration property of particles as a degree of agglomeration, which cannot be achieved by a conventional single particle size distribution measuring instrument.

Also, besides the viscosity of conductive paste and the filling into via property, for example, in the filling process shown in Fig. 8, regarding such phenomenon that conductive particles remain on the surface of releasing film 11, that is so-called variation not only due to the diameter of particle but to the agglomeration property of particles, it can be explained by using the degree of agglomeration. That is, the above problem can be solved by managing the degree of agglomeration.

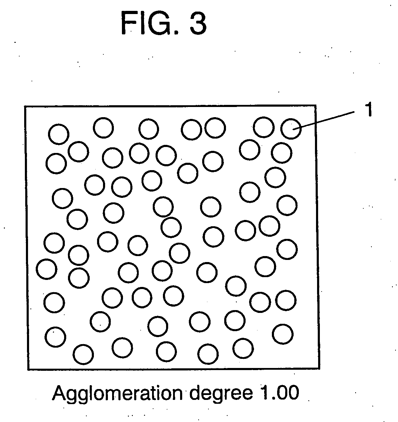

Fig. 2 and Fig. 3 are plan views schematically showing conductive particles different in agglomeration degree from conductive particles described in Fig. 1. In Fig. 2 and Fig. 3, the agglomeration degrees are respectively 3.90 and 1.00.

The conductive particles shown in Fig. 2 are stronger in agglomeration property than those shown in Fig. 1. Also, the conductive particles shown in Fig. 3 are those in a state of being separated almost without agglomeration of primary particles 1. Theoretically, the agglomeration degree should be 1.00, but in the calculation of agglomeration degrees from actually measured values, the result includes some variation due to difference in measuring instrument between primary particle and agglomerate and to the method of spherical approximation.

As conductive particles related to the present invention, it is desirable to use those ranging from 1.05 to 3.90 in agglomeration degree. Thus, it is possible to keep the paste viscosity at a low level while maintaining the connection reliability of the via-hole conductor.

When the agglomeration degree is less than 1.05, the viscosity lowering effect of conductive paste is remarkable, but the resistance value of via-hole conductor worsens, affecting the conducting connection reliability. On the other hand, when the agglomeration degree exceeds 3.90, the conducting connection reliability of via-hole conductor is satisfactory, but the dispersibility of conductive paste is not improved and the viscosity lowering effect becomes lowered.

A method of obtaining such agglomerate forming appropriate aggregate will be described in the following. Various kinds of conductive particles can be the favorite for achieving the purpose. Actually, however, it is preferable to select conductive particles formed by a dry chemical reduction or electrolytic process, or a dry atomization or grinding process. In the preferred embodiment 1, dried copper powder deposited through wet chemical reduction reaction is employed. The agglomeration degree of this copper powder is 4.60. As a method of controlling the individual state of agglomeration, it is a method of relieving the individual state of agglomeration, in which the agglomeration degree of particles is lowered through disaggregation by giving energy to particles in a state of being agglomerated.

As a method of giving energy, it is preferable to directly apply an air flow to the particles by using a jet stream or to throw the particles into a rotary device which generates centrifugal forces so that wind-force energy is relatively given to them. Here, an air classifier "Turbo Classifier" of Nisshin Engineering is used for the execution of disaggregation.

The original method of using this device is a method of particle classification by particle diameters. In the present invention, the purpose is to give wind-force energy to the agglomerate. That is, classification is not the purpose, but disaggregation is the purpose. The level of energy given during disaggregation, that is, the strength of disaggregation is controlled by the rotating speeds, processing frequencies and time, thereby obtaining several kinds of copper powder including the one that is 1.60 in agglomeration degree.

An aggregate generated with such conductive particles formed by a wet or dry process is loosened by a disaggregation process, and as a result, it brings about an effect of lowering the viscosity of the conductive paste to a level appropriate for printing and filling into through-holes.

Even in case the agglomeration degree is 3.90 or less, the disaggregation process can be executed because the effect of lowering the viscosity is greater when the agglomeration degree is lower. For example, it is also possible to change conductive particles being 2.5 in agglomeration degree to those being less or for example 1.60 in agglomeration degree through disaggregation. Further, as the conductive particle of the present invention, it is desirable to be 1.0wt% or less in surface oxygen concentration. Thus, excellent conductor resistance being less in film oxide on the conductor surface can be obtained. Also, if the agglomeration degree exceeds 1.0w%, there arises such phenomenon that electrical connection between particles is affected by the insulating layer of surface oxide or surface oxygen atom is chemically or physically linked to the binder component based on thermosetting resin, causing the viscosity of conductive paste to increase.

Also, the adsorption water concentration of conductive particles is desirable to be 1000 ppm or less, and then, highly reliable via-hole conductor being excellent in printing characteristics can be formed.

If the adsorption water concentration exceeds 1000 ppm, the adsorption reaction will be promoted causing the pot life to shorten, and the viscosity of the conductive paste will be increased causing the printability to worsen. Also, it will worsen the hardening property of thermosetting resin. The adsorption water concentration can be relatively easily adjusted to 1000 ppm or less by drying the conductive particles.

In the present invention, the primary particle is spherical for the convenience of description. However, in the case of presupposing that particles are formed by a wet chemical reduction process, electrolytic process, or a dry atomizing process or grinding process, you are requested to understand that it includes particles a little warped in shape in the form of a lump having irregular surfaces or formed of fine crystal grains instead of being truly spherical.

The conductive paste manufacturing method related to the preferred embodiment 1 with the above copper powder blended will be described in the following.

As described above, using 87.5wt% of copper powder of 1.60 (shown in Fig. 1) in agglomeration degree, obtained through disaggregation of copper powder formed by a wet reduction process, as conductive particles, and 10.9wt% of dimeric acid diglycygyl ester epoxy resin (Epikote 871 of Japan Epoxy Resin Co.,Ltd.), a binder was obtained by adding 1.6wt% of amine adduct hardener (Amicure MY-24 of Ajinomoto Fine-Techno Co.,), which was kneaded by means of a ceramic 3-roll machine to obtain a conductive paste.

It is possible to obtain an effect of assuring the connection reliability of via-hole conductor and fluidity by uniformly dispersing the conductive particles forming appropriate aggregates into the binder.

In the preferred embodiment 1, copper powder is used as conductive particles and its content is 87.5wt%, but the content by volume is important and it varies with specific gravity of the conductive particle used. As the content by volume of conductive particles in the present invention, it is desirable to be in a range of 30 to 70vol%, and if it exceeds 70vol%, the binder content will be less than 30vol%, causing the viscosity of conductive paste to greatly increase, and it will become very difficult to make a paste.

On the other hand, if the binder content is contained exceeding 70vol%, the conductive particle content will be 30vol%, causing the contact between conductive particles in via-hole to become inadequate because the amount of the conductive particles is insufficient, and it will invite remarkable increase of the resistance value.

As thermosetting resin, component of the conductive paste, dimeric acid diglycysyl ester epoxy resin is used in the preferred embodiment 1. However, in accordance with the characteristics required for the via-hole conductor, it is possible to give some characteristics, for example, by increasing the cross-linking density, giving it flexibility, or raising the glass transition point (Tg). Also, it is preferable to use epoxy resin selected from the group consisting of glycysyl ether epoxy resin such as bisphenol F epoxy resin, bisphenol A epoxy resin, and bisphenol AD epoxy resin, and alicyclic epoxy resin, glycysyl amine epoxy resin, and glycysyl ester epoxy resin, individually or by mixing two or more of them.

Also, besides the epoxy resin above mentioned, it is possible to use polyamide resin, cyanate ester resin, phenol resol resin as a binder component.

The conductive paste described above is non-solvent type. However, in accordance with the characteristics required for the via-hole conductor, it is also possible to let it contain additives like a solvent dispersing agent such as butyl carbitol, butyl carbitol acetate, ethyl carbitol, ethyl carbitol acetate, butyl cellsolve, ethyl cellsolve, $\alpha$-turpyonel.

The volatile amount as conductive paste is desirable to be 4.0wt% or less as against the total weight. Thus, the high reliability of via-hole conductor can be assured. If the volatile amount exceeds 4.0 wt%, the volatile component in the via-hole will increase, and it may cause the conducting connection reliability of the via-hole conductor to worsen or swelling to be generated.

As for the copper paste of epoxy type obtained as described above, the viscosity was measured by an E-type viscometer, and it was 18 Pa·s at 0.5 rpm (shear rate Is$^{-1}$), using R14/3° cone, and 38 Pa·s at 5 rpm. As another embodiment, copper powder different in agglomeration degree was used, but the description is omitted because the manufacturing method is same as described above, and the obtained viscosity of the conductive paste will be described in the preferred embodiment 2.

(Preferred embodiment 2)

The circuit forming board related to the preferred embodiment 2 of the present invention will be described in the following.

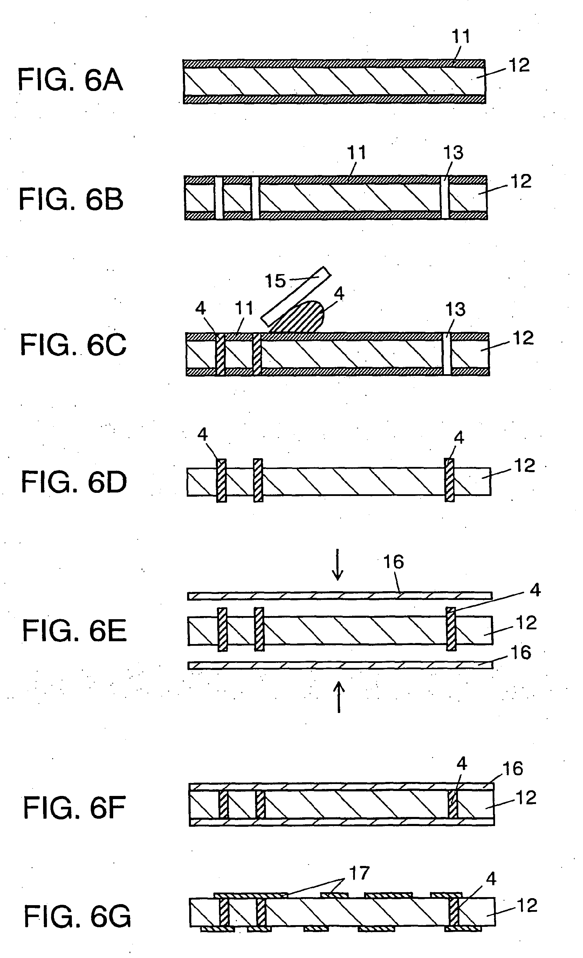

Fig. 6A to Fig. 6G are sectional views showing the manufacturing process of a circuit forming board related to the present invention.

First, as shown in Fig. 6A, non-woven cloth of aramid fiber is impregnated with epoxy resin, and PET (polyethylene phthalate) film 11 of 20 μm thick which is formed by applying a releasing agent of silicone type or the like is laminated by a laminator onto both surfaces of insulating board (prepreg sheet) 12 in a state of being half-hardened (B-stage) which is 120 μm in thickness and 500mm × 340mm in size.

Subsequently, as shown in Fig. 6B, through-hole 13 of φ200 μm in via-diameter is formed by a carbon dioxide laser beam at a predetermined position of insulating board (prepreg sheet) 12.

Next, as shown in Fig. 6C, conductive paste 4 manufactured in the preferred embodiment 1 is thrown into a filling machine (not shown) and filled into through-hole 13 from above releasing film 11.

When filling, it is placed on a printing machine table (not shown), and the filling operation is executed by a printing method using squeegee 15 such as urethane rubber.

In this case, releasing film 11 serves as a printing mask or contamination preventing film for insulating board (prepreg sheet) 12.

Next, as shown in Fig. 6D, after releasing film 11 is removed from both surfaces of insulating board (prepreg sheet) 12, as shown in Fig. 6E, insulating board (prepreg sheet) 12 is sandwiched between copper foils of 18 μm thick with both sides roughed as metallic foils 16. Subsequently, as shown in Fig. 6F, insulating board (prepreg sheet) 12 and metallic foils 16 are bonded to each other by a hot press (not shown) for heating and pressurizing. Simultaneously, conductive paste 4 is filled into insulating board (prepreg sheet) 12 and through-hole 13 and compressed therein. Thus, metallic foils 16 on both surfaces are electrically connected by conductive paste 4.

After that, as shown in Fig. 6G, metallic foils 16 on both surfaces are selectively etched to form wiring pattern 17, thereby obtaining a circuit forming board. Although the detailed description is omitted, copper foil of 18 μm thick with both sides roughened is used as metallic foil in the preferred embodiment 2 as described above, but it is preferable to use copper foil with one side glossed. Also, it is possible to use copper foil of 35 μm or 12 μm thick, and one with a thin carrier, or metallic foil other than copper foil.

Also, the heat and pressure conditions of the hot press can be decided according to the insulating board (prepreg sheet) 12 selected and the composition of conductive paste. In the preferred embodiment 2, the heat and pressure conditions are set to 200°C of press temperature, 4.9Mpa (50 kgf/cm$^2$) of pressure, and 60 minutes of pressurizing time.

Also, in the preferred embodiment 2, for measuring the resistance value of conductive via, the test pattern manufactured is of 30,000 via in total number of via-holes, in which resistance measuring pieces each with 500 via series-connected as a circuit are arranged by 5 lines × 12 rows.

Also, a circuit forming board of φ150 μm in via-diameter was obtained similarly with respect to prepreg sheet (substrate B) that is equivalent to FR-4 or FR-5 with woven cloth of glass fiber impregnated with epoxy resin which is a material different from the above prepreg sheet as substrate A..

The compressibility of two types of prepreg sheet used for a circuit forming board in the preferred embodiment 2 is 15.8% for substrate A (aramid/epoxy) and 10.5% for substrate B (glass/epoxy).

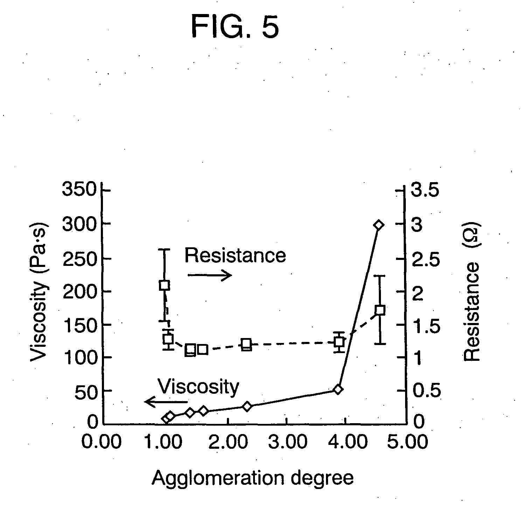

Next, in a circuit forming board formed as mentioned above, the relationship between the agglomeration degree of copper powder used for conductive paste 4 of the present invention, the viscosity of conductive paste, and the conduction resistance of via-hole will be described with reference to Table 1 and Fig. 5.

Table 1

| Sample No. | Agglomeration degree | Viscosity (Pa·s) | Substrate A/Via diameter φ200 μm | | Substrate B/Via diameter φ150 μm | | Remarks |
|---|---|---|---|---|---|---|---|
| | | | Board resistance (Ω) | Standard deviation | Board resistance (Ω) | Standard deviation | |
| Comparative example 1 | 1.00 | 7 | 2.10 | 0.18 | 2.90 | 0.46 | Corresponding to Fig. 3 |
| Embodiment 1 | 1.05 | 10 | 1.28 | 0.05 | 1.80 | 0.07 | |
| Embodiment 2 | 1.39 | 15 | 1.12 | 0.01 | 1.61 | 0.04 | |
| Embodiment 3 | 1.41 | 15 | 1.13 | 0.01 | 1.63 | 0.04 | Without disaggregation |
| Embodiment 4 | 1.60 | 18 8 | 1.13 | 0.02 | 1.58 | 0.05 | Corresponding to Fig. 1 |
| Embodiment 5 | 2.34 | 25 | 1.20 | 0.03 | 1.64 | 0.05 | |
| Embodiment 6 | 3.90 | 50 | 1.22 | 0.05 | 1.66 | 0.08 | Corresponding to Fig. 2 |
| Comparative example 2 | 4.60 | 300 | 1.70 | 0.17 | 2.10 | 0.22 | |

* Viscosity: measured by using R14/3° cone at 0.5 rpm (RE-80U made by Toki Sangyo Co.,Ltd.)
* Substrate A → Aramid/epoxy prepreg (via diameter = φ200 µm)
* Substrate B → Glass/epoxy prepreg (via diameter = φ150 µm)
* Board resistance: average value of series resistance for via-hole conductor 500 via (including wiring resistance 0.7Ω)

As shown in Table 1, the conductive particles of conductive paste in the preferred embodiment 2 are in a range from 1.05 to 3.90 in agglomeration degree. The board resistance value is the average value of series resistance of 500 via. For example, in substrate A, the value is 1.12Ω (embodiment 2) to 1.28Ω (embodiment 1), that is, the electric conductivity obtained is very excellent.

Particularly, when the agglomeration degree shown in embodiment 2 of Table 1 is 1.39, the board resistance is a minimum of 1.1Ω, and the standard deviation representing the variation of resistance value is also a minimum of 0.01. This is suggestive of the fact that when the agglomeration degree of conductive particles is around 1.39, in the case of microscopic observation of inner via-hole, the contact between conductive particles is in best condition for conductor resistance, and the dispersibility of conductive particles in conductive particles is excellent, and as a result, the variation in amount of conductive particles filled into individual via-holes is suppressed.

When the agglomeration degree is less than 1.05, the board resistance value becomes larger as shown in comparative example 1 of Table 1, and the standard deviation value also becomes larger. Also, this tendency is more remarkable in substrate B that is lower in compressibility.

On the other hand, as is obvious in Fig. 5 showing the result for substrate A of Table 1, the viscosity is lowered along with decrease in agglomeration degree. The decrease of agglomeration degree is closely correlated with the dispersibility of conductive paste, and when the agglomeration degree is less than 1.05, that is, in a state of being extremely dispersed, the viscosity of conductive paste is low and the liquidity is excellent. However, it invites such a result that the conducting connection of via-hole cannot be satisfied. From this fact, it can be predicted that when the agglomeration degree becomes increasingly lowered, the dispersibility is too much improved, and the conductive particles are uniformly dispersed in a binder based on thermosetting resin being an insulating material, and in inner via-hole, the contact between conductive particles becomes lessened or unstable.

On the other hand, if the agglomeration degree of conductive particles exceeds 3.90, the viscosity of conductive paste is greatly increased due to its agglomeration property, and the filling property will be affected when the conductive paste is filled into through-hole 13 disposed in insulating board (prepreg sheet) 12. Also, when releasing film 11 is removed, conductive paste sticking to the edge of releasing film 11 at through-hole 13 is removed along with releasing film 11, resulting in generation of a so-called "paste off" phenomenon.

Accordingly, as shown in Fig. 5, the resistance tends to rather increase, increasing in variation of the resistance value. Also, in the case of conductive paste with high viscosity exceeding 3.90 in agglomeration degree of the conductive particles, the number of sheets of insulating boards (prepreg sheet) 12 capable of via-filling with respect to a specific amount of paste is decreased, worsening the productivity, and the cost requirement cannot be satisfied. As shown in Table 1, the worsening tendency of resistance due to the agglomeration degree exceeding 3.90 is remarkable because the situation is worse when through-hole 13 is smaller in via-diameter. From these reasons, the upper limit of agglomeration degree of conductive particles of the present invention is desirable to be 3.90 or less.

As conductive particles in the preferred embodiment 2, copper powder deposited through wet chemical reduction reaction is dried, and an example of using copper powder whose agglomeration degree is 1.41 without disaggregation is shown in the embodiment 3 of Table 1.

Thus, irrespective of whether disaggregation is executed or not, the viscosity of conductive paste and the resistor resistance are tending to depend upon agglomeration degree, and even in the case of copper powder subjected to disaggregation, the tendency is the same as in the case of executing no disaggregation.

However, for controlling the agglomeration degree without executing disaggregation, for example, in wet chemical reduction reaction that gives influences to agglomeration degree, it is necessary to strictly control the reaction conditions such as temperatures, concentrations, and state of stirring, and various conditions such as drying temperatures, amount of water absorbed, and surface treating agents for preventing aggregation.

Accordingly, a method of disaggregating agglomerate by adding external energy to the agglomerate as already described will be able to provide an excellent method by which the agglomeration can be easily and reliably controlled at low costs.

For dispersing conductive particles of the present invention into a binder in high densities, the average particle diameter is desirable to be in a range from 0.5 to 20 µm, and the specific surface area, from 0.07 to 1.7 m$^2$/g.

If the average particle diameter is less than 0.5 µm, the particle diameter is too small, and the specific surface area will become larger, exceeding 1.7 m$^2$/g, and the conductive particles will become hard to be dispersed into the binder in high densities. On the other hand, if the average particle diameter exceeds 20 µm, the number of conductive particles filled into one via-hole will be decreased, and as a result, the contact opportunity and contact area between the conductive particles will be reduced, causing the board resistance to increase.

Also, if the specific surface area is less than 0.07 $m^2$/g, it will be difficult to make the average particle diameter of conductive particle 20 μm or less, and if it exceeds 1.7 $m^2$/g, conductive particles will be hard to disperse at high densities because the viscosity of conductive paste is extremely increased.

(Preferred embodiment 3)

A circuit forming board using conductive paste with particle size distribution controlled and its conductive paste will be described in the following.

The configuration other than conductive particles in the conductive paste related to the preferred embodiment 3 and the manufacturing method for a circuit forming board using the conductive paste are same as described in the preferred embodiment 1 and preferred embodiment 2, and the detailed description is omitted.

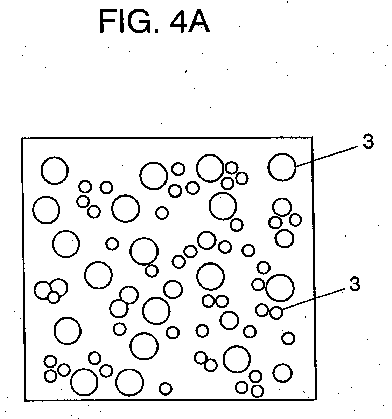

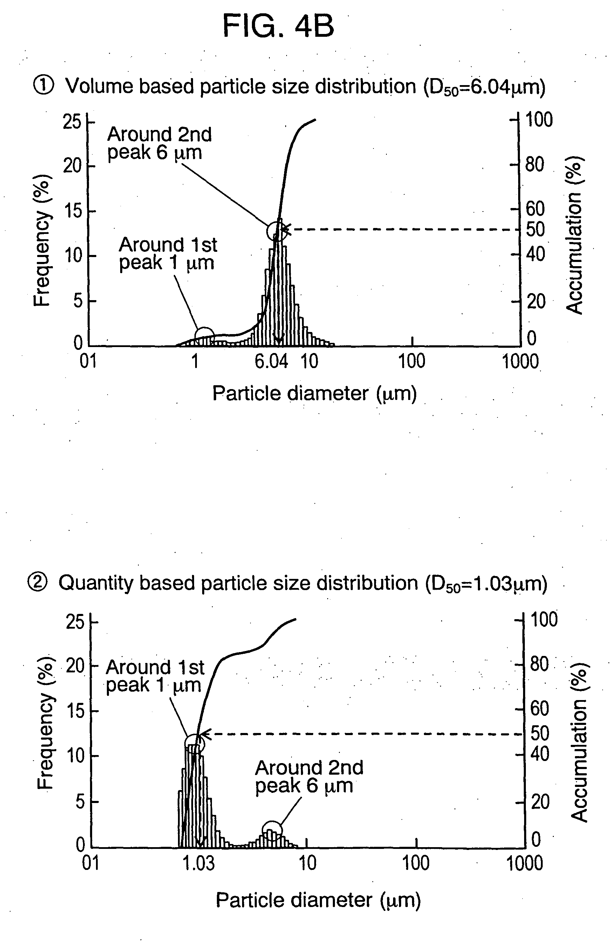

Fig. 4A and Fig. 4B are diagrams showing one embodiment of particle size distribution of copper powder related to the preferred embodiment 3, each of which represent same sample.

Copper powder used in the preferred embodiment 3 is nearly the same as described in the preferred embodiments 1 and 2 in its manufacturing method. As a method of improving the dispersibility of conductive paste, it is given at least two peaks of different particle diameters.

Specifically, as conductive particle 3 employed in the preferred embodiment 3, the particle size distribution is desirable to have at least two peaks in 0.2 to 10 μm and 6 to 20 μm of average particle diameters. If it exceeds the above range, it will be difficult for the conductive particles to be 0.5 to 20 μm in average particle diameter and 0.07 to 1.7 $m^2$/g in specific, surface area. Here, the peak of particle size distribution is described by using Fig. 4B.

Fig. 4 B (1) and Fig. 4 B (2) show the measuring charts of particle size distribution measured by using a Microtrack(Made by Nikkiso Co.,Ltd.), wet laser diffraction scattering system, as a particle size distribution measuring instrument.

In the particle size distribution chart, the frequency with particles classified by particle diameters is shown on the left vertical axis to show the frequency distribution. The peak of particle size distribution stands for a portion rising like a mound at which the frequency is maximum in a specific range of particle size of the frequency distribution. In the figure, the encircled (O) portions are the peaks. Of the particle diameter, the first peak is around 1 μm, and the second peak is around 6 μm.

Also, the portion between the peaks of particle size distribution is not always required to be completely concave in shape, and it is allowable to be gently continuous. The average particle diameter of conductive particles is the value of particle diameter when the accumulation value of the frequency distribution becomes 50%, and the peak of particle size distribution is different in meaning from average particle diameter.

Further, a laser diffraction scattering system is here used for the measurement of particle size distributions in the description, but it is also preferable to employ other methods such as an electrical resistance system represented by a Coulter counter and an image processing method.

As a method of forming a particle size distribution peak, it is preferable to prepare two or more kinds of powder having particle size distributions of different average particle diameters, and for example, to mix them by using a V-type mixer. Also, it is possible to form three or more peaks of particle size distributions by eliminating intermediate particle diameters through classification.

Also, as a method without mixing and classification, for example, it is possible to control the particle diameter during reaction in a wet chemical reduction process. Also, as another method, it is preferable to control the particle diameter by providing two or more jet nozzles in an atomizing process. In any case, there is no particular limitation on the forming method for providing particle size distributions with peaks.

Fig. 4B (1) and Fig. 4 B (2) are particle size distributions of conductive particles in the preferred embodiment 3, showing the particle size distributions measured by using a M icrotrack(Made by Nikkiso Co.,Ltd.), the wet laser diffraction scattering system mentioned above, as a particle size distribution measuring instrument. Of the particle size distribution, the first peak exists around 1 μm of particle diameter, and the second peak exists around 6 μm of particle diameter, which is copper powder with 5wt% and 95wt% respectively mixed therein.

Generally, the average particle diameter is the value calculated from the frequency with particles classified by particle diameters, and it corresponds to the particle diameter when the accumulation value becomes 50%. The average particle diameter of powder obtained by mixing greatly varies depending upon whether the calculation is made in accordance with the volume standard or quantity standard.

Fig. 4 B is an example of measuring particle size distributions in accordance with the volume standard and quantity standard with respect to same copper powder above mentioned. The average particle diameters ($D_{50}$) are respectively 6.04 and 1.03. The particle size distribution of conductive particles related to the conductive paste of the present invention has at least two peaks as its feature, and there is no particular problems with respect to the calculation standard.

Next, a circuit forming board is formed by the same manufacturing method as in the preferred embodiment 2, and the relationship between the peak value of particle size distribution of copper powder used for the conductive paste of the present invention, the viscosity of conductive paste, and the conducting resistance of via-hole will be described with reference to Table 2 and Fig. 4.

Table 2

| Sample No. | 1st peak (μm) | 2nd peak (μm) | 3rd peak (μm) | Viscosity (Pa·s) | Substrate A/Via diameter φ200 μm | | Substrate B/Via diameter φ150 μm | | Remarks |
|---|---|---|---|---|---|---|---|---|---|
| | | | | | Board resistance (Ω) | Standard deviation | Board resistance (Ω) | Standard deviation | |
| Embodiment 7 | 1 | 6 | - | 18 | 1.28 | 0.05 | 1.70 | 0.08 | Corresponding to Fig. 4 |
| Embodiment 8 | 0.7 | 11 | - | 17 | 1.25 | 0.03 | 1.78 | 0.07 | |
| Embodiment 9 | 9 | 15 | - | 23 | 1.35 | 0.03 | 1.76 | 0.05 | |
| Embodiment 10 | 0.7 | 8 | 17 | 15 | 1.22 | 0.05 | 1.68 | 0.08 | |
| Comparative example 3 | 7 | - | - | 300 | 1.70 | 0.17 | 2.10 | 0.22 | Same as comparative example 2 |
| Comparative example 4 | 0.7 | | | Unable | - | - | - | - | Unable to be formed into paste |

* Viscosity: measured by using R14/3° cone at 0.5 rpm (RE-80U made by Toki Sangyo Co.,Ltd.)
* Substrate A → Aramid/epoxy prepreg (via diameter = $\phi$200 μm)
* Substrate B → Glass/epoxy prepreg (via diameter = $\phi$150 μm)
* Board resistance: average value of series resistance for via-hole conductor 500 via (including wiring resistance 0.7Ω)

Comparative example 3 and comparative example 4 in Table 2 are those with only one peak of particle distribution, of which the agglomeration degree is not controlled.

In any of the examples, conductive particles are hard to be dispersed into a binder, and comparative example 4 in particular is unable to be formed into paste.

It is clear that in the embodiments 7 to 10 of Table 2, using copper powder of different particle diameters, excellent conductive paste can be obtained, and a circuit forming board using the paste has excellent conducting connection characteristics.

Thus, when the conductive particle of the present invention is given at least two peaks, for example, as shown by the schematic diagram in Fig. 4A, it is configured in that relatively small particles corresponding to the first peak of particle size distribution get in between relatively large-diameter particles corresponding to the second peak of particle size distribution, and also, the agglomeration of small particles is suppressed, and small particles serve the function just like "rollers" for large particles, thereby improving the dispersibility. That is, powder of different particle diameters results in generation of liquidity and has an effect to reduce the viscosity.

Also, the particle size distribution of conductive particles of the present invention is not always required to have two peaks only. As shown in the embodiment 2 of Table 2, the effect peculiar to the present invention can be obtained even when having three peaks or more. Also, the mixing ratio can be properly selected in accordance with the via-diameter of through-hole to be filled, the kind of conductive particles used, and the size of particle diameter.

Also, in the circuit forming board in each preferred embodiment of the present invention, the prepreg sheets used are non-woven cloth of aramid fiber impregnated with epoxy resin (aramid/epoxy) and woven cloth of glass fiber impregnated with epoxy resin (glass/epoxy), but other usable fibers include PBO (polyparaphenylene benzobisoxazole), PBI (polybenzoimidazole), PBZT (polyparaphenylene benzobisthiazole), or organic fiber or inorganic fiber such as total aromatic polyester. Also, besides epoxy resin for impregnation, it is possible to use polyimide resin, phenol resin, fluororesin, unsaturated polyester resin, PPE (polyphenylene ester) resin, thermosetting resin or thermoplastic resin such as cyanate resin. The compressibility of the above two types of prepreg sheets is respectively 15.8% for (aramid/epoxy) and 10.5% for (glass/epoxy), and it is also possible to use a substrate being lower or higher in compressibility.

Also, in each preferred embodiment of the present invention described above, copper is used as a material for conductive particles in the description, but it is needless to say that the effect peculiar to the present invention can be obtained by using conductive particles classified into the following (I) to (IV).

(I) Gold, platinum, silver, palladium, copper, nickel, tin, lead, indium.
(II) Alloy particles of a combination selected from the group consisting of gold, platinum, silver, palladium, copper, nickel, tin, lead, indium, zinc, chrome, bismuth.
(III) Particles coated with at least one kind of metal selected from the group consisting of gold, platinum, silver, palladium, copper, nickel, tin, lead, indium, zinc, chrome.
(IV) Particles coated with alloy of a combination selected from the group consisting of gold, platinum, silver, palladium, copper, nickel, tin, lead, indium, zinc, chrome, and bismuth, having a metal, inorganic mater or organic particle as a core.

By selecting from the above classification, it is possible to satisfy the using conditions and required characteristics of the circuit forming board, and the manufacturing conditions.

Also, as the conductive particles related to the conductive paste of the present invention, it is possible to use the conductive particles provided with a surfacing agent such as organic fatty acid or silane coupling agent for the purpose of dispersion and rust-proofing.

INDUSTRIAL APPLICABILITY

As is obvious in each of the above preferred embodiments, according to the present invention, it is possible to supply a conductive paste excellent in fluidity and dispersibility by using conductive particles properly forming agglomerate with 0.5 to 20 μm in average particle diameter and 0.07 to 1.7 $m^2$/g in specific surface area.

And due to the conductive paste excellent in fluidity and dispersibility, the filling into via property and the contact between conductive particles in via-hole are stabilized, and a high-quality via-hole conductor can be reliably formed without excessive variation, and it is possible to provide a circuit forming board having excellent connection reliability and being inexpensive, which is used for a high-frequency circuit capable of high-speed transmission as a high-density circuit forming board, fine wiring pattern for semiconductor package, and portable electronic apparatus required to be reduced in size and weight.

**Claims**

1. A conductive paste comprising: conductive particles comprising primary particles and agglomerate of primary particles, which are 0.5 to 20 μm in average particle diameter and 0.07 to 1.7 $m^2$/g in specific surface area, and a binder based on thermosetting resin.

2. A conductive paste comprising: conductive particles of 0.5 to 20 μm in average particle diameter and 0.07 to 1.7 $m^2$/g in specific surface area, having at least two peaks of particle size distribution, and a binder based on thermosetting resin.

3. A conductive paste comprising: conductive particles formed by mixing conductive particles of at least two different particle size distributions, and a binder based on thermosetting resin.

4. The conductive paste of claim 1, wherein the agglomeration degree of the agglomerate (agglomeration degree = agglomerate average particle diameter/primary particle average diameter) is within a range from 1.05 to 3.90.

5. The conductive paste of claim 1, wherein the primary particle is spherical, and the agglomerate is formed of at least two of the primary particles agglomerated.

6. The conductive paste of claim 1, wherein the agglomerate has been disaggregated.

7. The conductive paste of any one of claim 1 to claim 3, wherein the content of the conductive particles ranges from 30 to 70 vol%, and the content of the binder ranges from 70 to 30 vol%.

8. The conductive paste of any one of claim 1 to claim 3, wherein the content of volatile matter as against the total weight is 4.0 wt% or less.

9. The conductive paste of any one of claim 1 to claim 3, wherein the adsorption water concentration of the conductive particles is 1000 ppm or less.

10. The conductive paste of any one of claim 1 to claim 3, wherein the surface oxygen concentration of the conductive particles is 1.0 wt% or less.

11. The conductive paste of any one of claim 1 to claim 3, wherein the binder comprises dimeric acid diglycysile ester epoxy resin and amine adduct hardener.

12. The conductive paste of any one of claim 1 to claim 3, wherein the binder is selected from the group consisting of glycysile ether epoxy resin such as bisphenol F epoxy resin, bisphenol A epoxy resin, and bisphenol AD epoxy resin, alicyclic epoxy resin, glycysile amine epoxy resin, and glycysile ester epoxy resin.

13. The conductive paste of any one of claim 1 to claim 3, wherein the conductive particles are one kind of particles at least selected from the group consisting of gold, platinum, silver, palladium, copper, nickel, tin, lead, and indium.

14. The conductive paste of any one of claim 1 to claim 3, wherein the conductive particles are alloy particles of a combination selected from the group consisting of gold, platinum, silver, palladium, copper, nickel, tin, lead, indium, zinc, chrome, and bismuth.

15. The conductive paste of any one of claim 1 to claim 3, wherein the conductive particles are particles coated with at least one kind of metal selected from the group consisting of gold, platinum, silver, palladium, copper, nickel, tin, lead, indium, zinc, and chrome, having a metal, inorganic matter or organic particle as a core.

16. The conductive paste of any one of claim 1 to claim 3, wherein the conductive particles are particles coated with alloy of a combination selected from the group consisting of gold, platinum, silver, palladium, copper, nickel, tin, lead, indium, zinc, chrome, and bismuth, having a metal, inorganic matter or organic particle as a core.

17. A conductive paste manufacturing method comprising the steps of: preparing conductive particles, measuring agglomeration degrees of the conductive particles (agglomeration degree = agglomerate average diameter/primary particle average diameter), disaggregating the conductive particles according to the measured result of agglomeration degree, and adding a binder thereto and kneading.

18. A conductive paste manufacturing method comprising the steps of:

   preparing conductive particles having at least two peaks of particle size distribution, and adding a binder thereto and kneading.

19. A conductive paste manufacturing method comprising the steps of:

   preparing conductive particles of at least two different particle size distributions, mixing them, and adding a binder thereto and kneading.

20. The conductive paste manufacturing method of any one of claim 17 to claim 19, wherein the step of preparing conductive particles is a step of drying copper powder deposited by a wet chemical reduction process.

21. The conductive paste manufacturing method of claim 17, wherein the step of disaggretating the conductive particles according to the measured result of agglomeration degree is a disaggregation step executed when the measured result of agglomeration exceeds 3.90.

22. The conductive paste manufacturing method of claim 17, wherein the disaggregation step is executed by directly applying a jet stream to the agglomerate.

23. The conductive paste manufacturing method of claim 17, wherein the disaggregating step is executed by putting the agglomerate into a centrifugal rotation device and rotating the centrifugal rotation device.

24. The conductive paste manufacturing method of claim 17, wherein the agglomeration degree of conductive particles after disaggregation is within a range from 1.05 to 3.90.

25. A circuit board manufacturing method that is a method of measuring conductive particles including primary particles and agglomerate of primary particles, comprising the steps of obtaining the average diameter of primary particles, obtaining the average diameter of agglomerate, and as agglomeration degree, dividing the average particle diameter of agglomerate by the average particle diameter of primary particles.

26. The conductive paste manufacturing method of claim 25, wherein the step of obtaining average particle diameter of primary particles is a step of image analysis of observed images of conductive particles, and the step of obtaining the average particle diameter of agglomerate is a step of measuring conductive particles by using a laser diffraction scattering type particle size distribution measuring instrument.

27. The conductive paste manufacturing method of claim 26, wherein the image observation of conductive particles is executed by using SEM (scanning electron microscope), CCD camera, or optical microscope.

28. A circuit forming board comprising an insulating board, a plurality of wiring patterns formed on the insulating board, and via-hole conductor electrically connecting the wiring patterns, wherein the conductive paste of any one of claim 1 to claim 3 is used as the via-hole conductor.

29. A circuit board manufacturing method comprising at least the steps of:

   affixing releasing film formed with a releasing layer on at least one side thereof to one or both surfaces of an insulating board, making a through-hole for forming via-hole conductor in the insulating board provided with the releasing film, filling the conductive paste of claim 1 into the through-hole, and removing the releasing film.

# FIG. 1

Agglomeration degree 1.60

# FIG. 2

Agglomeration degree 3.90

# FIG. 3

Agglomeration degree 1.00

FIG. 4A

# FIG. 4B

① Volume based particle size distribution (D$_{50}$=6.04μm)

② Quantity based particle size distribution (D$_{50}$=1.03μm)

# FIG. 5

FIG. 6A

FIG. 6B

FIG. 6C

FIG. 6D

FIG. 6E

FIG. 6F

FIG. 6G

FIG. 7A

FIG. 7B

FIG. 7C

FIG. 7D

FIG. 7E

FIG. 7F

FIG. 7G

# FIG. 8A

# FIG. 8B

Heating
and
pressurizing

[Substrate compressibility (%) = $(t_0 - t_1) / t_0 \times 100$]

# FIG. 9

REFERENCE NUMERALS IN THE DRAWINGS

1      Primary particle
2      Agglomerate
3, 18  Conductive particle
4.14   Conductive paste
11     Releasing film
12     Insulating board (prepreg sheet)
13     Through-hole
15     Squeegee
16     Metallic foil
17     Wiring pattern
19     Binder component

## INTERNATIONAL SEARCH REPORT

International application No.

PCT/JP2004/000460

A. CLASSIFICATION OF SUBJECT MATTER
Int.Cl$^7$  H01B1/20, H05K1/11, 3/40, 1/09

According to International Patent Classification (IPC) or to both national classification and IPC

B. FIELDS SEARCHED

Minimum documentation searched (classification system followed by classification symbols)
Int.Cl$^7$  H01B1/20, H05K1/11, 3/40, 1/09

Documentation searched other than minimum documentation to the extent that such documents are included in the fields searched
Jitsuyo Shinan Koho          1922–1996    Toroku Jitsuyo Shinan Koho      1994–2004
Kokai Jitsuyo Shinan Koho     1971–2004    Jitsuyo Shinan Toroku Koho      1996–2004

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| E,X | JP 2004-47856 A  (Sumitomo Metal (SMI) Electronics Devices Inc.), 12 February, 2004 (12.02.04), Par. Nos. [0013], [0014], [0016] to [0019], [0024] to [0030], [0034], [0035] (Family: none) | 1-5,7,8,13, 14,18,19,28 |
| P,X | JP 2003-268402 A  (Shin-Etsu Chemical Co., Ltd.), 25 September, 2003 (25.09.03), Par. Nos. [0020] to [0022], [0033], [0025], [0057] to [0059], [0060], [0062], [0064]; table 1 (Family: none) | 18-20 |

[×]  Further documents are listed in the continuation of Box C.          [ ]  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 26 April, 2004 (26.04.04) | 18 May, 2004 (18.05.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

### INTERNATIONAL SEARCH REPORT

| | International application No. |
|---|---|
| | PCT/JP2004/000460 |

C (Continuation).  DOCUMENTS CONSIDERED TO BE RELEVANT

| Category* | Citation of document, with indication, where appropriate, of the relevant passages | Relevant to claim No. |
|---|---|---|
| P,X | JP 2003-141929 A  (Mitsui Mining & Smelting Co., Ltd.), 16 May, 2003 (16.05.03), Par. Nos. [0014], [0016] to [0018], [0024] to [0026], [0028], [0037] (Family: none) | 18-20 |
| P,X | JP 2003-92024 A  (Matsushita Electric Industrial Co., Ltd.), 28 March, 2003 (28.03.03), Par. Nos. [0011], [0015], [0017], [0026], [0030], [0053] to [0060]; Fig. 4 (Family: none) | 18,19 |
| X<br>Y<br>A | JP 8-279665 A  (Matsushita Electric Industrial Co., Ltd.), 22 October, 1996 (22.10.96), Par. Nos. [0009] to [0013], [0022], [0023] (Family: none) | 18,19<br>20<br>1-17,21-29 |
| Y<br>A | JP 2002-343135 A  (Mitsui Mining & Smelting Co., Ltd.), 29 November, 2002 (29.11.02), Par. Nos. [0003], [0004], [0011], [0014], [0029], [0033], [0038] (Family: none) | 20<br>1,9,10,26,27 |
| A | JP 2000-297303 A  (Murata Mfg. Co., Ltd.), 24 October, 2000 (24.10.00), Par. Nos. [0014], [0024], [0025]; Fig. 3 (Family: none) | 6,17,21-24 |
| A | JP 7-176846 A  (Matsushita Electric Industrial Co., Ltd.), 14 July, 1995 (14.07.95), Claims 1, 4, 5, 17, 25, 26 & EP 651602 A1 | 1,7,8,10-12 |
| A | JP 2002-332501 A  (Mitsui Mining & Smelting Co., Ltd.), 22 November, 2002 (22.11.02), Par. No. [0038] (Family: none) | 26,27 |
| A | JP 6-262375 A  (Matsushita Electric Industrial Co., Ltd.), 20 September, 1994 (20.09.94), Par. Nos. [0031], [0032]; Figs. 3, 4 & EP 576872 A1 | 29 |

Form PCT/ISA/210 (continuation of second sheet) (January 2004)